# EUROPÄISCHE PATENTSCHRIFT

(11) **EP 1 911 108 B1**
(45) Veröffentlichungstag und Bekanntmachung des Hinweises auf die Patenterteilung: **19.10.2011**
(21) Anmeldenummer: 06776454.8
(22) Anmeldetag: 27.07.2006
(51) Int. Cl.: H01L 51/05

(54) **VERFAHREN ZUR HERSTELLUNG EINES ELEKTRONISCHEN BAUELEMENTS**
METHOD FOR PRODUCING AN ELECTRONIC COMPONENT
PROCEDE POUR PRODUIRE UN COMPOSANT ELECTRONIQUE

(30) Priorität: 29.07.2005 DE 102005035589
(43) Veröffentlichungstag der Anmeldung: 16.04.2008
(73) Patentinhaber: PolyIC GmbH & Co. KG, 90763 Fürth (DE)
(72) Erfinder: KNOBLOCH, Alexander, 910542 Erlangen (DE); ULLMANN, Andreas, 90513 Zirndorf (DE); FIX, Walter, 90427 Nürnberg (DE); WELKER, Merlin, 91083 Baiersdorf (DE)
(74) Vertreter: Zinsinger, Norbert
(86) Internationale Anmeldenummer: PCT/EP2006/007441
(87) Internationale Veröffentlichungsnummer: WO 2007/014694

(56) Entgegenhaltungen:
- WO-A2-2005/022664
- US-A- 2002 013 013
- US-A1- 2002 013 013
- US-A1- 2005 051 770
- KAWASE T ET AL: "Inkjet printing of polymer thin film transistors" PREPARATION AND CHARACTERIZATION, ELSEVIER SEQUOIA, NL, Bd. 438-439, 22. August 2003 (2003-08-22), Seiten 279-287, XP004448006 ISSN: 0040-6090
- BACKLUND T G ET AL: "Towards all-polymer field-effect transistors with solution processable materials" SYNTHETIC METALS, ELSEVIER SEQUOIA, LAUSANNE, CH, Bd. 148, Nr. 1, 3. Januar 2005 (2005-01-03), Seiten 87-91, XP004664964 ISSN: 0379-6779
- REDINGER D ET AL: "An all-printed passive component technology for low-cost RFID" DEVICE RESEARCH CONFERENCE, 2003 JUNE 23-25, 2003, PISCATAWAY, NJ, USA,IEEE, 23. Juni 2003 (2003-06-23), Seiten 187-188, XP010655172 ISBN: 0-7803-7727-3
- SUBRAMANIAN V ET AL: "Printed organic transistors for ultra-low-cost RFID applications" POLYMERS AND ADHESIVES IN MICROELECTRONICS AND PHOTONICS, 2004. POLYTRONIC 2004. 4TH IEEE INTERNATIONAL CONFERENCE ON PORTLAND, OR, USA 12-15 SEPT. 2004, PISCATAWAY, NJ, USA,IEEE, 12. September 2004 (2004-09-12), Seiten 67-71, XP010775926 ISBN: 0-7803-8744-9
- BURGHART M; LIEMIANN G; KLINK G; BOCK K: "Evaluation of reel-to-reel processes for polymer electronics", 3. INTERNATIONAL IEEE CONFERENCE ON POLYMERS AND ADHESIVES IN MICROELECTRONICS AND PHOTONICS, POLYTRONIC 2003, 20 October 2003 (2003-10-20), pages 287-293, XP009125073,
- MOHR J., HOLLENBACH U., LAST A., WALLRABE U.: "Polymer technologies: a way to low-cost micro-optical components and systems", PROCEEDINGS OF THE SPIE, vol. 5453 , pages 1-12, XP040186403,
- BURGHART M; LIEMIANN G; KLINK G; BOCK K: "Evaluation of reel-to-reel processes for polymer electronics" 3. INTERNATIONAL IEEE CONFERENCE ON POLYMERS AND ADHESIVES IN MICROELECTRONICS AND PHOTONICS, POLYTRONIC 2003, 20. Oktober 2003 (2003-10-20), Seiten 287-293, XP009125073
- MOHR J., HOLLENBACH U., LAST A., WALLRABE U.: "Polymer technologies: a way to low-cost micro-optical components and systems" PROCEEDINGS OF THE SPIE, Bd. 5453, Seiten 1-12, XP040186403

## Beschreibung

Die Erfindung betrifft ein Verfahren zur Herstellung eines elektronischen Bauelements auf einer Oberfläche eines Substrats, wobei das elektronische Bauelement mit, senkrecht zur Oberfläche des Substrats gesehen, mindestens zwei übereinander und zumindest in einem Flächenbereich F überlappend angeordneten elektrischen Funktionsschichten ausgebildet wird, wobei die mindestens zwei elektrischen Funktionsschichten auf dem Substrat direkt oder indirekt in einem kontinuierlichen Prozess strukturiert werden, wobei das Substrat relativ zu einer Strukturierungseinheit bewegt wird.

Ein derartiges Verfahren ist aus WO 2004/047144 A2 bekannt. Es wird ein organisches elektronisches Bauelement, wie ein organischer Feldeffekt-Transistor (OFET), Schaltungen mit solchen Bauelementen und ein Herstellungsverfahren beschrieben. Die Bildung des elektronischen Bauelements erfolgt über ein preisgünstiges Druckverfahren.

DE 101 26 859 A1 beschreibt ein Verfahren zur Erzeugung von leitfähigen Strukturen, damit.hergestellte aktive Bauelemente wie organische Feldeffekt-Transistoren (OFETs) oder organische Leuchtdioden (OLEDs) sowie Schaltungen mit derartigen Bauelementen. Die leitfähigen Strukturen wie Leiterbahnen bzw. Elektroden werden mittels Drucktechnik auf einer dünnen, flexiblen Kunststoff-Folie erzeugt, wobei alle bekannten Druckverfahren, insbesondere Tiefdruck, Hochdruck, Flachdruck, Durchdruck (Siebdruck) oder Tampondruck, als geeignet genannt sind.

Weiter beschreibt der Artikel "Inkjet printing of polymer thin film transistors" PREPARATION AND CHARACTERIZATION, ELSEVIER SEQUOIA, NL, Bd. 438-439, Seiten 279-287, ISSN: 0040-6090, Dünnfilm-Transistoren mittels Inkjet-Drucktechnik zu fertigen. Die Source-, Drain- und Gate-Elektroden werden gedruckt unter Verwendung eines leitfähigen Polymers. Der Halbleiter und das Gate-Dielektrikum werden mittels Spin-Coating aufgebracht. Als Halbleiter wird ein konjungiertes Polymer verwendet. Um die Auflösungs-Grenze der Inkjet-Drucktechnik zu überwinden, wird das leitfähige Polymer hierbei auf ein vorbearbeitetes Substrat aufgedruckt.

Die Anwendung von kontinuierlichen Prozessen bei der Herstellung von elektronischen Bauelementen ermöglicht deren preisgünstige Massenproduktion mit hohen Prozessgeschwindigkeiten. Um möglichst gleichmäßige elektrische Werte und die Funktionsfähigkeit eines elektronischen Bauelements zu erreichen, müssen die einzelnen elektrischen Funktionsschichten, aus denen das elektronische Bauelement aufgebaut wird, nacheinander gebildet und dabei übereinander in richtiger Lage und Anordnung gemäß einem vorgegebenen Layout positioniert werden. Je höher die Geschwindigkeit des Substrats und/oder der Strukturierungseinheit im kontinuierlichen Prozess gewählt wird, desto wahrscheinlicher ist ein Auftreten von Abweichungen im Bereich von der idealen Positionierung der elektrischen Funktionsschichten im Hinblick auf weitere, bereits auf dem Substrat vorhandene elektrische Funktionsschichten.

Eine direkte Bildung und gleichzeitige Strukturierung der elektrischen Funktionsschicht erfolgt vorzugsweise durch ein Druckverfahren. Alternativ kann eine elektrische Funktionsschicht aber auch mittels Laser oder Ätztechnik erst nach deren Bildung strukturiert werden. In beiden Fällen wird prozessabhängig ein Flächenanteil der elektrischen Funktionsschicht außerhalb der idealen Position, die durch das Layout vorgegeben war, ausgebildet.

Es ist nun Aufgabe der Erfindung, ein Verfahren zur Herstellung eines elektronischen Bauelements bereitzustellen, das auch bei hohen Prozessgeschwindigkeiten zu einem funktionsfähigen, elektronischen Bauelement mit den gewünschten elektrischen Kennwerten führt.

Die Aufgabe wird durch ein Verfahren nach Anspruch 1 gelöst.

Etwaige, zur elektrischen Kontaktierung der elektrischen Funktionsschichten benötigte elektrische Leitungen oder Bahnen werden dabei als nicht zur jeweiligen Funktionsschicht zugehörig betrachtet.

Wird das Substrat relativ zur Strukturierungseinheit bewegt, so wird darunter verstanden, dass entweder das Substrat selbst und/oder die Strukturierungseinheit bewegt werden kann. Dabei kann entweder nur das Substrat bewegt werden und die Strukturierungseinheit dabei unbeweglich sein, oder die Strukturierungseinheit beweglich und das Substrat dabei unbeweglich sein, oder aber sowohl das Substrat als auch die Strukturierungseinheit beweglich sein.

Das erfindungsgemäße Verfahren ermöglicht es, eine nach der Bildung einer derart dimensionierten ersten elektrischen Funktionsschicht zu bildende und im Hinblick auf die erste elektrische Funktionsschicht auszurichtende weitere elektrische Funktionsschicht mit äußerst geringem Aufwand zu positionieren, da eine geringfügige Abweichung von der idealen Positionierung der weiteren elektrischen Funktionsschicht sich nicht auf die Funktionsfähigkeit und die elektrischen Kennwerte des elektronischen Bauelements auswirkt. Ein mit dem erfindungsgemäßen Verfahren gebildetes elektronisches Bauelement toleriert demnach in Relativ-Bewegungsrichtung und/oder senkrecht zur Relativ-Bewegungsrichtung eine Abweichung vom Layout in der Positionierung der ersten elektrischen Funktionsschicht gegenüber einer weiteren elektrischen Funktionsschicht, je nach Lage der idealen Position der ersten elektrischen Funktionsschicht im Hinblick auf den Flächenbereich F. Dadurch kann die Prozessgeschwindigkeit weiter erhöht und die Wahrscheinlichkeit eines Auftretens von defekten elektronischen Bauelementen vermindert werden.

Besonders bevorzugt ist es dabei, wenn die erste Längendimension der ersten elektrischen Funktionsschicht in Relativ-Bewegungsrichtung um 50 bis 500µm länger ausgebildet wird als die Längendimension des Flächenbereichs F in Relativ-Bewegungsrichtung. Diese Auslegung stellt einen Kompromiss dar zwischen dem durch das Verfahren erforderlichen zusätzlichen Platzbedarf für die elektrischen Funktionsschichten und der Wahrscheinlichkeit eines Erzielens eines nicht oder nur eingeschränkt funktionierenden Bauelements.

Es hat sich bewährt, wenn die erste elektrische Funktionsschicht im Hinblick auf den Flächenbereich F derart positioniert wird, dass ein erster Flächenschwerpunkt der ersten elektrischen Funktionsschicht und ein Flächenschwerpunkt des Flächenbereichs F senkrecht zur Oberfläche des Substrats gesehen im Layout übereinander liegen. Die erste elektrische Funktionsschicht, überragt gemäß Layout den Flächenbereich F in Relativ-Bewegungsrichtung sowohl vorne als auch hinten, so dass ein Flächenschwerpunkt einer weiteren elektrischen Funktionsschicht in Relativ-Bewegungsrichtung sowohl mit einer negativen als auch positiven Abweichung von seiner idealen Position gemäß Layout positioniert werden kann. Die erste elektrische Funktionsschicht überragt gemäß Layout den Flächenbereich F senkrecht zur Relativ-Bewegungsrichtung an beiden Seiten, so dass ein Flächenschwerpunkt einer weiteren elektrischen Funktionsschicht senkrecht zur Relativ-Bewegungsrichtung sowohl mit einer negativen als auch positiven seitlichen Abweichung von seiner idealen Position gemäß Layout positioniert werden kann.

Es hat sich bewährt, wenn als kontinuierlicher Prozess ein Druckprozess, wie ein Tiefdruck-, Hockdruck-, Flachdruck-, Durchdruck- oder Tampondruck-Verfahren verwendet wird. Unter einem Durchdruck wird hierbei ein Siebdruck oder Schablonendruck verstanden.

Derartige Druckverfahren lassen sich mit hohen Prozessgeschwindigkeiten durchführen. Dabei kann eine elektrische Funktionsschicht direkt mittels Drucken unmittelbar und bereits in der gewünschten Form auf dem Substrat gebildet werden.

Weiterhin hat sich bewährt, wenn als kontinuierlicher Prozess ein Laserstrukturierungsverfahren oder ein Photolithographie-Strukturierungsverfahren verwendet wird, wobei unter dem Begriff Photolithographie-Strukturierungsverfahren hier generell alle mit Masken oder Maskierungsschichten arbeitenden Ätzverfahren verstanden werden.

Durch derartige Verfahren ist die indirekte Ausbildung beziehungsweise Formgebung einer elektrischen Funktionsschicht, die auf dem Substrat beispielsweise mittels Aufdampfen oder Sputtern gebildet worden ist, möglich. Dabei wird beispielsweise eine aufgedampfte elektrische Funktionsschicht bereichsweise mittels Laser entfernt. Bei der Positionierung des Lasers im Hinblick auf die bereits auf dem Substrat gebildete elektrische Funktionsschicht ergeben sich dabei üblicherweise geringe Abweichungen zur idealen Position, so dass eine Abweichung der gebildeten elektrischen Funktionsschicht zum Layout resultiert.

Wird ein Photolack vollflächig auf eine elektrische Funktionsschicht aufgetragen, über eine Maske belichtet, die nicht gehärteten Bereiche des Lacks entfernt, ein Ätzprozess durchgeführt und anschließend der Photolack entfernt, so ergeben sich durch geringe Abweichungen bei der Positionierung der Maske von ihrer idealen Position auch für die gebildete elektrische Funktionsschicht gegenüber dem Layout Lageabweichungen.

Weiterhin kann die elektrische Funktionsschicht beispielsweise mit einer ätzresistenten Maskenschicht bereits in den gewünschten Bereichen bedruckt und die nicht bedruckten Bereiche der elektrischen Funktionsschicht durch Ätzen entfernt werden. Anschließend wird die ätzresistente Maskenschicht abgelöst und die darunter verbliebenen, in der gewünschten Form strukturierten Bereiche der elektrischen Funktionsschicht freigelegt. Beim Drucken der Maskenschicht ergeben sich wie beim direkten Druck einer elektrischen Funktionsschicht ebenso Abweichungen von der idealen Position. Diese übertragen sich von der Maskenschicht direkt auf die damit strukturierte elektrische Funktionsschicht.

Weiterhin hat sich bewährt, wenn als kontinuierlicher Prozess ein Tintenstrahl-Strukturierungsverfahren verwendet wird, wobei hohe Prozessgeschwindigkeiten möglich sind. Dabei kann eine elektrische Funktionsschicht mittels Tintenstrahldruck unmittelbar und bereits in der gewünschten Form auf dem Substrat gebildet werden. Das Tintenstrahlverfahren ermöglicht aber auch den Auftrag einer Maskenschicht, um eine zuvor gebildete elektrische Funktionsschicht damit zu strukturieren.

Vorzugsweise wird eine Relativ-Geschwindigkeit des Substrats gegenüber der Strukturierungseinheit im kontinuierlichen Prozess im Bereich von 0,5 bis 200 m/min, vorzugsweise im Bereich von 10 bis 100 m/min, gewählt. Dies ermöglicht eine Massenfertigung von elektronischen Bauelementen bei geringen Herstellungskosten.

Besonders bevorzugt ist es dabei, wenn als Substrat ein flexibles Substrat, insbesondere eine langgestreckte Kunststoff-Folie, welche gegebenenfalls mehrschichtig ist, eingesetzt wird. Geeignet sind hierbei beispielsweise Kunststoff-Folien aus Polyester, Polyethylen, Polyethylenterephthalat oder Polyimid.

Es sich bewährt, wenn eine Dicke des Substrats im Bereich von 6µm bis 200µm, vorzugsweise im Bereich von 12µm bis 50µm, gewählt wird.

Bei einem flexiblen Substrat ist es insbesondere von Vorteil, wenn während des kontinuierlichen Prozesses ein Transport von Rolle zu Rolle vorgenommen wird. Dabei wird das unbeschichtete flexible Substrat auf eine Rolle aufgewickelt, das Substrat von der Rolle abgezogen und durch eine Prozessmaschine geführt, dabei strukturiert und schließlich als beschichtetes Substrat auf eine weitere Rolle aufgewickelt. Dies ermöglicht die Verarbeitung langer Substratbänder, wobei die Positionierung gegenüber der Prozessmaschine nur einmal zu Beginn einer neuen Substratrolle erfolgen muss.

Es hat sich bewährt, wenn die mindestens zwei elektrischen Funktionsschichten mit jeweils einer Schichtdicke im Bereich von 1nm bis 100µm, vorzugsweise im Bereich von 10nm bis 300nm, ausgebildet werden.

Die mindestens zwei elektrischen Funktionsschichten können im Querschnitt durch das Substrat gesehen im elektronischen Bauelement direkt aneinander angrenzend angeordnet werden. Die mindestens zwei elektrischen Funktionsschichten befinden sich somit in direktem Kontakt zueinander.

Alternativ kann zwischen den mindestens zwei elektrischen Funktionsschichten im Querschnitt durch das Substrat gesehen im elektronischen Bauelement mindestens eine dritte elektrische Funktionsschicht mindestens im Flächenbereich F angeordnet werden. Die mindestens zwei elektrischen Funktionsschichten befinden sich somit nicht in direktem Kontakt zueinander.

Dabei hat es sich bewährt, wenn die mindestens eine dritte elektrische Funktionsschicht senkrecht zur Oberfläche des Substrats gesehen den Flächenbereich F allseitig überragt, wobei eine dritte Längendimension der mindestens einen dritten elektrischen Funktionsschicht parallel zur Oberfläche des Substrats und in Relativ-Bewegungsrichtung um mindestens 5µm länger, vorzugsweise um mehr als 1mm länger, ausgebildet wird als die Längendimension des Fläclienbereichs F in Relativ-Bewegungsrichtung und parallel zur Oberfläche des Substrats und wobei eine dritte Breitendimension der dritten elektrischen Funktionsschicht parallel zur Oberfläche des Substrats und senkrecht zur Relativ-Bewegungsrichtung um mindestens 5µm breiter, vorzugsweise um mehr als 1mm breiter, ausgebildet wird als eine Breitendimension des Flächenbereichs F senkrecht zur Relativ-Bewegungsrichtung und parallel zur Oberfläche des Substrats.

Die erste elektrische Funktionsschicht wird als eine oder mehrere, insbesondere organische, Elektrode(n) ausgebildet.

Als leitfähige "organische" Materialien werden hier alle Arten von organischen, metallorganischen und anorganischen Kunststoffen angesehen, die im Englischen mit "plastics" bezeichnet werden. Eine Beschränkung im dogmatischen Sinn auf organisches Material als Kohlenstoff enthaltendes Material ist demnach nicht vorgesehen, sondern es ist vielmehr auch an den Einsatz von beispielsweise Silikonen gedacht. Weiterhin soll der Begriff keinerlei Beschränkung im Hinblick auf die Molekülgröße, insbesondere auf polymere und/oder oligomere Materialien unterliegen, sondern es ist durchaus auch der Einsatz von "small molecules" möglich. Als elektrisch leitfähige organische Materialien haben sich unter anderem Polyanilin oder Polypyrrol bewährt.

Als Elektrodenschicht für die erste elektrische Funktionsschicht eigenen sich aber auch aufgedampfte oder gesputterte Metallschichten, beispielsweise aus mindestens einem der Materialien Gold, Silber, Kupfer, Aluminium, Platin, Titan oder ähnlichem. Diese werden dann vorzugsweise mittels Laser oder Ätzen strukturiert.

Befindet sich die zweite elektrische Funktionsschicht in direktem Kontakt zur ersten elektrischen Funktionsschicht, dann hat es sich bewährt, wenn die zweite elektrische Funktionsschicht als, insbesondere organische, elektrische Isolationsschicht oder, insbesondere organische, Halbleiterschicht ausgebildet wird. Als organisches Isolationsmaterial hat sich unter anderem Polyvinylphenol bewährt. Als organisches Halbleitermaterial eignet sich beispielsweise Polythiophen.

Werden die erste und die zweite elektrische Funktionsschicht beabstandet voneinander angeordnet, so hat es sich bewährt, wenn die zweite elektrische Funktionsschicht als eine oder mehrere, insbesondere organische, Elektrode(n) ausgebildet wird. Als elektrisch leitfähige Materialien sind dabei ebenfalls die bereits oben für die als Elektrode ausgebildete erste elektrische Funktionsschicht genannten Materialien verwendbar.

Vorzugsweise wird als elektronisches Bauelement ein Feldeffekttransistor, ein Kondensator, eine Diode oder ein Bauelement mit mindestens einem Via, jeweils insbesondere mit mindestens einer organischen elektrischen Funktionsschicht, ausgebildet. Unter einem Via wird eine Öffnung, üblicherweise senkrecht zur Substratebene, verstanden, über welche eine elektrische Verbindung zwischen nicht direkt miteinander in Kontakt stehenden elektrischen Funktionsschichten eines Funktionsschichtstapels hergestellt wird. Auch bei der Ausbildung von Vias, beispielsweise über ein Ätzverfahren unter Einsatz einer Strukturierungsschicht, kann es zu Versetzungen der oben beschriebenen Art kommen, wobei eine Abweichung der Lage eines Vias von der idealen Position gemäß Layout über das erfindungsgemäße Verfahren ausgeglichen werden kann.

Die Figuren 1a bis 3b sollen die Erfindung beispielhaft erläutern. So zeigt:
- Figur 1a: eine Draufsicht auf ein beschichtetes Substrat, (nicht Teil der Erfindung)
- Figur 1b: einen Querschnitt A - A' durch das beschichtete Substrat gemäß Figur 1a,
- Figur 2a: eine Draufsicht auf ein weiteres beschichtetes Substrat,
- Figur 2b: einen Querschnitt B - B' durch das beschichtete Substrat gemäß Figur 2a,
- Figur 3a: eine Draufsicht auf ein weiteres beschichtetes Substrat, und
- Figur 3b: einen Querschnitt C - C' durch das beschichtete Substrat gemäß Figur 3a.

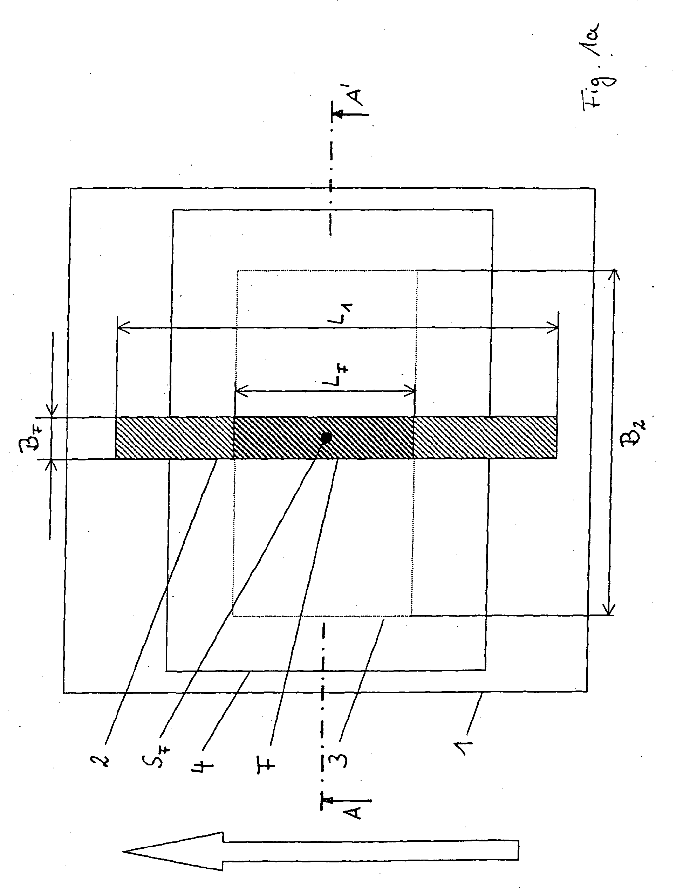

Figur 1a (nicht Teil der Erfindung) zeigt eine Draufsicht auf ein Substrat 1 aus PET-Folie, welches mit drei elektrischen Funktionsschichten 2, 3, 4 zur Herstellung eines elektronischen Bauelements, hier einer Diode, auf der Oberfläche des Substrats 1 bedruckt wurde. Senkrecht zur Oberfläche des Substrats 1 gesehen sind die elektrischen Funktionsschichten 2, 3, 4 übereinander und zumindest in einem Flächenbereich F überlappend angeordnet. Die elektrische Funktionsschicht 2 bildet dabei eine erste elektrische Funktionsschicht aus, wobei eine erste Längendimension L₁ der ersten elektrischen Funktionsschicht parallel zur Oberfläche des Substrats 1 und in Relativ-Bewegungsrichtung des Substrats 1 während des Bedruckens (in Figur 1a durch einen Pfeil links im Bild gekennzeichnet) um etwa 25µm länger ausgebildet wird als eine Längendimension L_{F} des Flächenbereichs F in Druckrichtung und parallel zur Oberfläche des Substrats 1. Die erste elektrische Funktionsschicht ist aus elektrisch leitendem Material, hier Kupfer, als Elektrode ausgebildet. Die elektrische Funktionsschicht 3 bildet eine zweite elektrische Funktionsschicht, die durch eine dritte elektrische Funktionsschicht 4 aus Poly3alkylthiphene von der ersten Funktionsschicht beabstandet ist. Die zweite elektrische Funktionsschicht ist aus Silber gebildet. Die zweite elektrische Funktionsschicht ist so ausgebildet worden, dass eine zweite Breitendimension B₂ der zweiten elektrischen Funktionsschicht parallel zur Oberfläche des Substrats 1 und senkrecht zur Relativ-Bewegungsrichtung um mindestens etwa 50µm breiter ausgebildet ist als eine Breitendimension B_{F} des Flächenbereichs F senkrecht zur Relativ-Bewegungsrichtung und parallel zur Oberfläche des Substrats 1. Die zur elektrischen Kontaktierung der ersten und zweiten elektrischen Funktionsschichten selbstverständlich erforderlichen elektrisch leitenden Zuleitungen oder Bahnen wurden nicht dargestellt.

Figur 1a zeigt den Idealfall gemäß dem Drucklayout für das elektronische Bauelement, bei welchem die erste elektrische Funktionsschicht im Hinblick auf den Flächenbereich F derart positioniert ist, dass ein erster Flächenschwerpunkt der ersten elektrischen Funktionsschicht und ein Flächenschwerpunkt S_{F} des Flächenbereichs F senkrecht zum Substrat 1 gesehen übereinander liegen und die zweite elektrische Funktionsschicht im Hinblick auf den Flächenbereich F derart positioniert ist, dass ein zweiter Flächenschwerpunkt der zweiten elektrischen Funktionsschicht und der Flächenschwerpunkt S_{F} des Flächenbereichs F senkrecht zum Substrat 1 gesehen ebenfalls übereinander liegen. In der Praxis ist dies allerdings aufgrund der beim Strukturieren auftretenden Abweichungen nicht der Fall.

Der in Figur 1a gezeigte Schichtaufbau ist tolerant gegenüber einer solchen Abweichung beziehungsweise Versetzung der ersten Funktionsschicht in Relativ-Bewegungsrichtung und/oder einer Abweichung beziehungsweise Versetzung der zweiten Funktionsschicht senkrecht zur Relativ-Bewegungsrichtung im Hinblick auf den dargestellten Idealfall gemäß dem Layout.

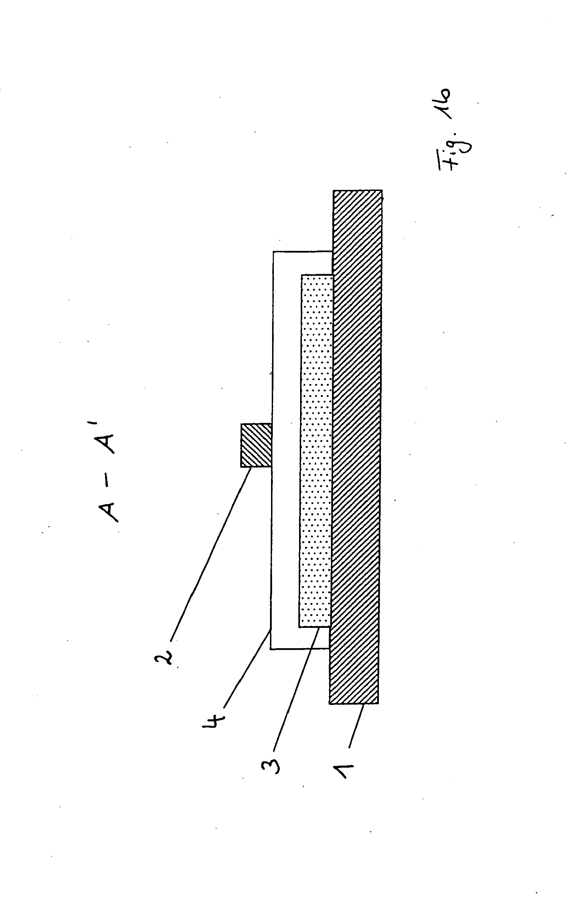

Figur 1b zeigt einen Querschnitt A - A' durch das bedruckte Substrat aus Figur 1a, wobei das Substrat 1 und die darauf gedruckten elektrischen Funktionsschichten 2, 3, 4 zu erkennen sind. Dabei bildet die elektrische Funktionsschicht 2 die erste elektrische Funktionsschicht, die elektrische Funktionsschicht 3 die zweite elektronische Funktionsschicht und die elektrische Funktionsschicht 4 eine dritte elektrische Funktionsschicht.

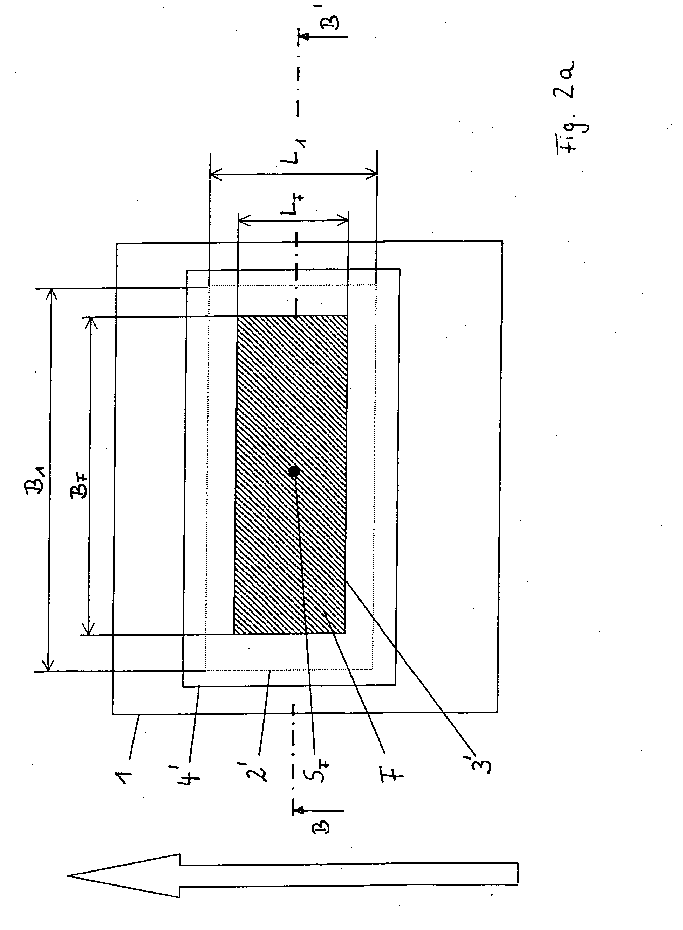

Figur 2a zeigt eine Draufsicht auf ein weiteres bedrucktes Substrat 1 aus PET-Folie, welches mit drei elektrischen Funktionsschichten 2', 3', 4' zur Herstellung eines elektronischen Bauelements, hier eines Kondensators, auf der Oberfläche des Substrats 1 bedruckt ist. Senkrecht zur Oberfläche des Substrats 1 gesehen sind die elektrischen Funktionsschichten 2', 3', 4' übereinander und zumindest in einem Flächenbereich F überlappend angeordnet. Die elektrische Funktionsschicht 2' bildet dabei eine erste elektrische Funktionsschicht aus, wobei eine erste Längendimension L₁ der ersten elektrischen Funktionsschicht parallel zur Oberfläche des Substrats 1 und in Relativ-Bewegungsrichtung des Substrats 1 während des Bedruckens des Substrats 1 (in Figur 2a durch einen Pfeil links im Bild gekennzeichnet) um etwa 1mm länger ausgebildet wird als eine Längendimension L_{F} des Flächenbereichs F in Relativ-Bewegungsrichtung und parallel zur Oberfläche des Substrats 1. Die erste elektrische Funktionsschicht ist aus elektrisch leitendem Material, hier Kupfer, als Elektrode ausgebildet. Die elektrische Funktionsschicht 3' bildet eine weitere elektrische Funktionsschicht, die durch eine dritte elektrische Funktionsschicht 4' aus elektrisch isolierendem Polymer von der ersten Funktionsschicht beabstandet ist. Die weitere elektrische Funktionsschicht ist als Silberelektrode ausgebildet.

Die erste elektrische Funktionsschicht ist so ausgebildet worden, dass eine erste Breitendimension B₁ der ersten elektrischen Funktionsschicht parallel zur Oberfläche des Substrats 1 und senkrecht zur Relativ-Bewegungsrichtung etwa 600µm breiter ausgebildet ist als eine Breitendimension B_{F} des Flächenbereichs F senkrecht zur Druckrichtung und parallel zur Oberfläche des Substrats 1. Die zur elektrischen Kontaktierung der ersten und weiteren elektrischen Funktionsschicht erforderlichen elektrisch leitenden Zuleitungen oder Bahnen wurden nicht dargestellt.

Figur 2a zeigt den Idealfall gemäß dem Drucklayout für das elektronische Bauelement, bei welchem die erste elektrische Funktionsschicht im Hinblick auf den Flächenbereich F derart positioniert ist, dass ein erster Flächenschwerpunkt der ersten elektrischen Funktionsschicht und ein Flächenschwerpunkt S_{F} des Flächenbereichs F senkrecht zum Substrat 1 gesehen übereinander liegen und die dritte sowie die weitere elektrische Funktionsschicht im Hinblick auf den Flächenbereich F derart positioniert sind, dass deren jeweiliger Flächenschwerpunkt und der Flächenschwerpunkt S_{F} des Flächenbereichs F senkrecht zum Substrat 1 gesehen ebenfalls übereinander liegen. In der Praxis ist dies allerdings aufgrund der beim Drucken auftretenden Abweichungen nicht der Fall. Der in Figur 2a gezeigte Schichtaufbau ist tolerant gegenüber einer solchen Abweichung beziehungsweise Versetzung der ersten Funktionsschicht in Relativ-Bewegungsrichtung und/oder einer Abweichung beziehungsweise Versetzung der ersten Funktionsschicht senkrecht zur Relativ-Bewegungsrichtung im Hinblick auf den dargestellten Idealfall gemäß dem Drucklayout.

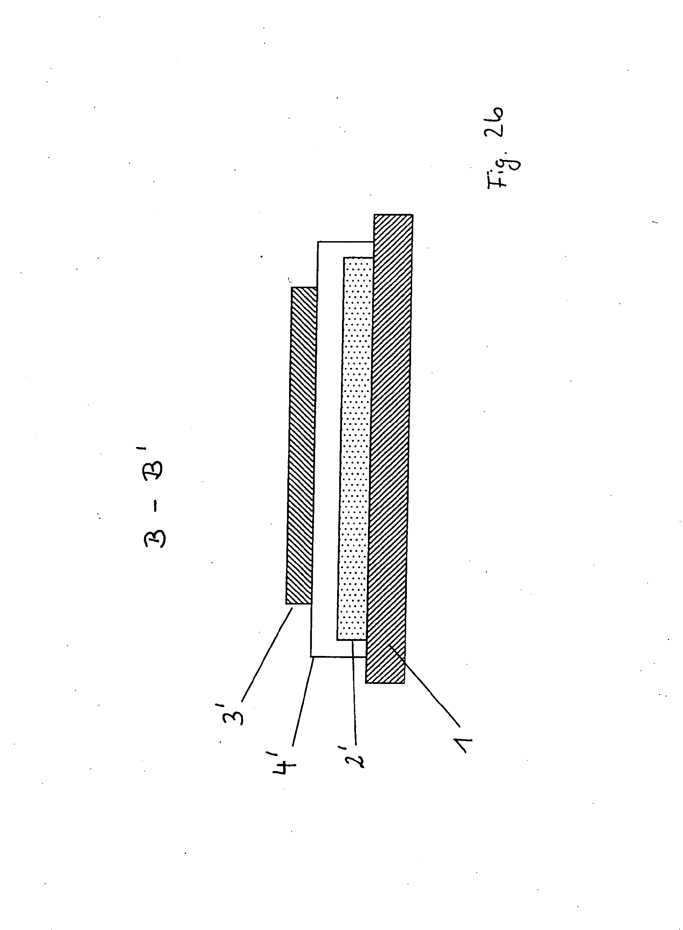

Figur 2b zeigt einen Querschnitt B - B' durch das bedruckte Substrat 1 aus Figur 2a, wobei das Substrat 1 und die darauf gedruckten elektrischen Funktionsschichten 2', 3', 4' zu erkennen sind. Dabei bildet die elektrische Funktionsschicht 2' die erste elektrische Funktionsschicht, die elektrische Funktionsschicht 3' bildet die weitere elektrische Funktionsschicht und die elektrische Funktionsschicht 4' bildet die dritte elektrische Funktionsschicht.

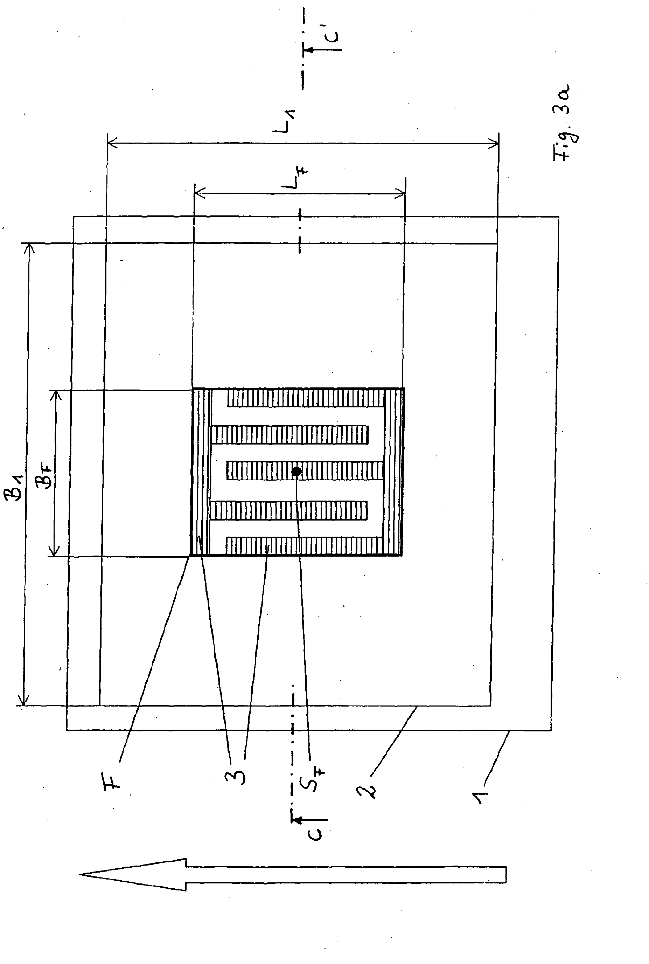

Figur 3a zeigt eine Draufsicht auf ein weiteres bedrucktes Substrat 1 aus PET-Folie, welches mit zwei elektrischen Funktionsschichten 2, 3 als Vorstadium zur Herstellung eines elektronischen Bauelements, hier beispielsweise eines organischen Feldeffekt-Transistors (OFET), auf der Oberfläche des Substrats 1 bedruckt ist. Senkrecht zur Oberfläche des Substrats 1 gesehen sind die elektrischen Funktionsschichten 2, 3 übereinander und zumindest in einem Flächenbereich F (begrenzt durch eine fettgedruckte Line) überlappend angeordnet. Die elektrische Funktionsschicht 2 bildet dabei eine erste elektrische Funktionsschicht aus, wobei eine erste Längendimension L₁ der ersten elektrischen Funktionsschicht parallel zur Oberfläche des Substrats 1 und in einer Relativ-Bewegungsrichtung des Substrats 1 während des Bedruckens des Substrats 1 (in Figur 3a durch einen Pfeil links im Bild gekennzeichnet) um etwa 1mm länger ausgebildet wird als eine Längendimension L_{F} des Flächenbereichs F in Relativ-Bewegungsrichtung und parallel zur Oberfläche des Substrats 1. Die erste elektrische Funktionsschicht ist aus halbleitenden Material, hier Polyalkylthiophen, ausgebildet. Die elektrische Funktionsschicht 3 bildet eine weitere elektrische Funktionsschicht. Die weitere elektrische Funktionsschicht ist aus Silber gebildet und in Form von zwei Kammstrukturen, die die Source- und Drain-Elektroden des OFET ausbilden sollen, gestaltet. Nachdem die elektrische Funktionsschicht 3 hier eine unregelmäßige Form besitzt, wird der Flächenbereich F in diesem Fall so definiert, dass die maximalen äußeren Abmessungen (in Relativ-Bewegungsrichtung und senkrecht dazu) der elektrischen Funktionsschicht 3 den Umfang des Flächenbereichs F vorgeben, obwohl innerhalb des so definierten Flächenbereichs F nicht an jeder Stelle eine Überlappung der beiden elektrischen Funktionsschichten vorliegt. Diese Definition des Flächenbereichs F ist hier zweckmäßig, da es beim Bedrucken der Kammstruktur mit der ersten Funktionsschicht darauf ankommt, die Kammstruktur vollständig zu bedecken.

Die erste elektrische Funktionsschicht ist so ausgebildet worden, dass eine erste Breitendimension B₁ der ersten elektrischen Funktionsschicht parallel zur Oberfläche des Substrats 1 und senkrecht zur Relativ-Bewegungsrichtung etwa 1mm breiter ausgebildet ist als eine Breitendimension B_{F} des Flächenbereichs F senkrecht zur Relativ-Bewegungsrichtung und parallel zur Oberfläche des Substrats 1. Die zur elektrischen Kontaktierung der ersten und weiteren elektrischen Funktionsschichten gegebenenfalls erforderlichen elektrisch leitenden Zuleitungen oder Bahnen wurden nicht dargestellt.

Figur 3a zeigt den Idealfall gemäß dem Drucklayout für das elektronische Bauelement, bei welchem die erste elektrische Funktionsschicht im Hinblick auf den Flächenbereich F derart positioniert ist, dass ein erster Flächenschwerpunkt der ersten elektrischen Funktionsschicht und ein Flächenschwerpunkt S_{F} des Flächenbereichs F senkrecht zum Substrat 1 gesehen übereinander liegen und die weitere elektrische Funktionsschicht im Hinblick auf den Flächenbereich F derart positioniert ist, dass deren Flächenschwerpunkt und der Flächenschwerpunkt S_{F} des Flächenbereichs F senkrecht zum Substrat 1 gesehen ebenfalls übereinander liegen. In der Praxis wird dies allerdings aufgrund der beim Drucken auftretenden Abweichungen nicht der Fall sein. Der in Figur 3a gezeigte Schichtaufbau ist tolerant gegenüber einer solchen Abweichung beziehungsweise Versetzung der ersten Funktionsschicht in Relativ-Bewegungsrichtung und/oder einer Abweichung beziehungsweise Versetzung der ersten Funktionsschicht senkrecht zur Relativ-Bewegungsrichtung im Hinblick auf den dargestellten Idealfall gemäß dem Drucklayout.

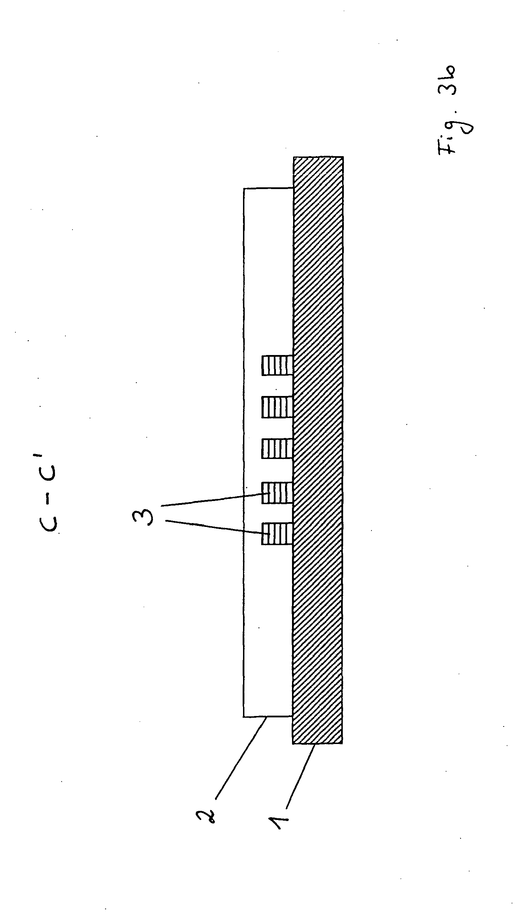

Figur 3b zeigt einen Querschnitt C - C' durch das bedruckte Substrat 1 aus Figur 3a, wobei das Substrat 1 und die darauf gedruckten elektrischen Funktionsschichten 2, 3 zu erkennen sind. Dabei bildet die elektrische Funktionsschicht 2 die erste elektrische Funktionsschicht und die elektrische Funktionsschicht 3 eine weitere elektrische Funktionsschicht.

Es wird darauf hingewiesen, dass die Figurendarstellungen 2a bis 3b den Grundgedanken der Erfindung lediglich beispielhaft erläutern und dass sich für den Fachmann aus dem Gesamtzusammenhang viele weitere Möglichkeiten ergeben, das erfindungsgemäße Verfahren auch für die Bildung von elektrischen Funktionsschichten anderer elektrischer Bauelemente in kontinuierlichen Prozessen einzusetzen, ohne dabei den Erfindungsgegenstand zu verlassen.

## Patentansprüche

1. Verfahren zur Herstellung eines elektronischen Bauelements auf einer Oberfläche eines Substrats (1), wobei das elektronische Bauelement mit, senkrecht zur Oberfläche des Substrats (1) gesehen, mindestens zwei übereinander und zumindest in einem Flächenbereich F überlappend angeordneten elektrischen Funktionsschichten (2, 2', 3, 3', 4, 4') ausgebildet wird, wobei die mindestens zwei elektrischen Funktionsschichten (2, 2', 3, 3', 4, 4') auf dem Substrat (1) direkt oder indirekt in einem kontinuierlichen Prozess strukturiert werden, wobei das Substrat (1) relativ zu einer Strukturierungseinheit bewegt wird, wobei als Substrat (1) ein flexibles Substrat mit einer Dicke im Bereich von 6 µm bis 200 µm eingesetzt wird, das während des kontinuierlichen Prozesses von Rolle zu Rolle transportiert wird, wobei
a) eine erste elektrische Funktionsschicht der mindestens zwei elektrischen Funktionsschichten (2, 2', 3, 3',4, 4') so strukturiert wird, dass eine erste Längendimension (L₁) der ersten elektrischen Funktionsschicht parallel zur Oberfläche des Substrats (1) und in einer Relativ-Bewegungsrichtung des Substrats (1) relativ zu der Strukturierungseinheit um mindestens 5µm länger ausgebildet wird als eine Längendimension (L_{F}) des Flächenbereichs F in Relativ-Bewegungsrichtung und parallel zur Oberfläche des Substrats (1), wobei die erste elektrische Funktionsschicht als eine oder mehrere Elektrode(n) ausgebildet wird und wobei
b) eine erste elektrische Funktionsschicht der mindestens zwei elektrischen Funktionsschichten (2, 2', 3, 3',4, 4') so strukturiert wird, dass eine erste Breitendimension (B₁) der ersten elektrischen Funktionsschicht parallel zur Oberfläche des Substrats (1) und senkrecht zu einer Relativ-Bewegungsrichtung des Substrats (1) relativ zu der Strukturierungseinheit um mindestens 5µm breiter ausgebildet wird als eine Breitendimension (B_{F}) des Flächenbereichs F senkrecht zur Relativ-Bewegungsrichtung und parallel zur Oberfläche des Substrats (1).

2. Verfahren nach Anspruch 1,
**dadurch gekennzeichnet,**
**dass** die erste Längendimension (L₁) der ersten elektrischen Funktionsschicht in Relativ-Bewegungsrichtung um 50 bis 500µm länger ausgebildet wird als die Längendimension (L_{F}) des Flächenbereichs F in Relativ-Bewegungsrichtung.

3. Verfahren nach einem der Ansprüche 1 oder 2,
**dadurch gekennzeichnet,**
**dass** die erste elektrische Funktionsschicht im Hinblick auf den Flächenbereich F in einem Layout derart positioniert wird, dass ein erster Flächenschwerpunkt der ersten elektrischen Funktionsschicht und ein Flächenschwerpunkt (S_{F}) des Flächenbereichs F senkrecht zum Substrat (1) gesehen übereinander liegen.

4. Verfahren nach einem der Ansprüche 1 bis 3,
**dadurch gekennzeichnet,**
**dass** als kontinuierlicher Prozess ein Druckprozess, wie ein Tiefdruck-, Hochdruck-, Flachdruck-, Durchdruck-, oder Tampondruck-Verfahren, ein Laserstrukturierungsverfahren, oder ein Photolithographie-Strukturierungsverfahren eingesetzt wird.

5. Verfahren nach einem der Ansprüche 1 bis 4,
**dadurch gekennzeichnet,**
**dass** eine Relativ-Geschwindigkeit des Substrats (1) gegenüber der Strukturierungseinheit im kontinuierlichen Prozess im Bereich von 0,5 bis 200 m/min gewählt wird.

6. Verfahren nach einem der Ansprüche 1 bis 5,
**dadurch gekennzeichnet,**
**dass** als Substrat (1) eine langgestreckte Kunststoff-Folie eingesetzt wird.

7. Verfahren nach Anspruch 6,
**dadurch gekennzeichnet,**
**dass** eine Dicke des Substrats (1) im Bereich von 12µm bis 50µm gewählt wird.

8. Verfahren nach einem der Ansprüche 1 bis 7,
**dadurch gekennzeichnet,**
**dass** die mindestens zwei elektrischen Funktionsschichten (2, 2', 3, 3', 4, 4') mit jeweils einer Schichtdicke im Bereich von 1nm bis 100µm ausgebildet werden.

9. Verfahren nach Anspruch 8,
**dadurch gekennzeichnet,**
**dass** die mindestens zwei elektrischen Funktionsschichten (2, 2', 3, 3', 4, 4') mit jeweils einer Schichtdicke im Bereich von 10nm bis 300nm ausgebildet werden.

10. Verfahren nach einem der Ansprüche 1 bis 9,
**dadurch gekennzeichnet,**
**dass** die mindestens zwei elektrischen Funktionsschichten (2, 2', 3, 3', 4, 4') im Querschnitt durch das Substrat (1) gesehen im elektronischen Bauelement direkt aneinander angrenzend angeordnet werden.

11. Verfahren nach einem der Ansprüche 1 bis 9,
**dadurch gekennzeichnet,**
**dass** zwischen den mindestens zwei elektrischen Funktionsschichten (2, 2', 3, 3', 4, 4') im Querschnitt durch das Substrat (1) gesehen im elektronischen Bauelement mindestens eine dritte elektrische Funktionsschicht mindestens im Flächenbereich F angeordnet wird.

12. Verfahren nach Anspruch 11,
**dadurch gekennzeichnet,**
**dass** die mindestens eine dritte elektrische Funktionsschicht senkrecht zur Oberfläche des Substrats (1) gesehen den Flächenbereich F allseitig überragt, wobei eine dritte Längendimension der mindestens einen dritten elektrischen Funktionsschicht parallel zur Oberfläche des Substrats (1) und in Relativ-Bewegungsrichtung um mindestens 5µm länger, ausgebildet wird als die Längendimension (L_{F}) des Flächenbereichs F in Relativ-Bewegungsrichtung und parallel zur Oberfläche des Substrats (1) und wobei eine dritte Breitendimension der dritten elektrischen Funktionsschicht parallel zur Oberfläche des Substrats (1) und senkrecht zur Relativ-Bewegungsrichtung um mindestens 5µm breiter, ausgebildet wird als eine Breitendimension (B_{F}) des Flächenbereichs F senkrecht zur Relativ-Bewegungsrichtung und parallel zur Oberfläche des Substrats (1).

13. Verfahren nach Anspruch 10,
**dadurch gekennzeichnet,**
**dass** die zweite elektrische Funktionsschicht als elektrische Isolationsschicht oder Halbleiterschicht ausgebildet wird.

14. Verfahren nach Anspruch 11,
**dadurch gekennzeichnet,**
**dass** die zweite elektrische Funktionsschicht als eine oder mehrere Elektrode(n) ausgebildet wird.

15. Verfahren nach einem der Ansprüche 1 bis 14,
**dadurch gekennzeichnet,**
**dass** als elektronisches Bauelement ein Feldeffekttransistor, ein Kondensator, eine Diode oder ein Bauelement enthaltend mindestens ein Via, jeweils mit mindestens einer organischen elektrischen Funktionsschicht, ausgebildet wird.

## Claims

1. Process for production of an electronic component on a surface of a substrate (1), whereby the electronic component, seen perpendicularly to the surface of the substrate (1) is designed with at least two electrical functional layers (2, 2', 3, 3', 4, 4') arranged one on top of the other and overlapping at least in a surface region F, whereby the at least two electrical functional layers (2, 2', 3, 3', 4, 4') are directly or indirectly structured on the substrate (1) in a continuous process, whereby the substrate (1) is moved relative to a structuring unit, whereby a flexible substrate with a thickness in the region of 6µm to 200µm is used as a substrate (1), which is transported from roll to roll during the continuous process, whereby
a) a first electrical functional layer of the at least two electrical functional layers (2, 2', 3, 3', 4, 4') is structured in such a way that a first longitudinal dimension (L₁) of the first electrical functional layer, parallel to the surface of the substrate (1) and in a relative movement direction of the substrate (1) relative to the structuring unit, is designed at least 5µm longer than a longitudinal dimension (L_{F}) of the surface region F in the relative movement direction and parallel to the surface of the substrate (1), whereby the first electrical functional layer is designed as one or several electrodes, and whereby
b) a first electrical functional layer of the at least two electrical functional layers (2, 2', 3, 3', 4, 4') is structured in such a way that a first width dimension (B₁) of the first electrical functional layer parallel to the surface of the substrate (1) and perpendicular to a relative movement direction of the substrate (1) relative to the structuring unit is designed at least 5µm wider than a width dimension (B_{F}) of the surface region F perpendicular to the relative movement direction and parallel to the surface of the substrate (1).

2. Process according to claim 1,
**characterised in that**
the first longitudinal dimension (L₁) of the first electrical functional layer in the relative movement direction is designed about 50 to 500µm longer than the longitudinal dimension (L_{F}) of the surface region F in the relative movement direction.

3. Process according to claim 1 or 2,
**characterised in that**
the first electrical functional layer, with regard to the surface area F, is designed in a layout in such a way that a first centre of gravity of the area of the first electrical functional layer and a centre of gravity of the area (S_{F}) of the surface region F lie one on top of the other, seen perpendicularly to the substrate (1).

4. Process according to one of claims 1 to 3,
**characterised in that**
a printing process, such as a low pressure process, high pressure process, flat printing process, print through process or pad printing process, laser structuring process or a photolithography structuring process is used as a continuous process.

5. Process according to any one of claims 1 to 4,
**characterised in that**
a relative speed of the substrate (1) in relation to the structuring unit in the continuous process is selected in the region of 0.5 to 200m/min.

6. Process according to any of one claims 1 to 5,
**characterised in that**
an elongated plastic film is used as a substrate (1).

7. Process according to claim 6,
**characterised in that**
a thickness of the substrate (1) is selected in the region of 12µm to 50µm.

8. Process according to any one of claims 1 to 7,
**characterised in that**
the at least two electrical functional layers (2, 2', 3, 3', 4, 4') are designed each with a layer thickness in the region of 1 nm to 100µm.

9. Process according to claim 8,
**characterised in that**
the at least two electrical functional layers (2, 2', 3, 3', 4, 4') are designed each with a layer thickness in the region of 10nm to 300nm.

10. Process according to any one of claims 1 to 9,
**characterised in that**
the at least two electrical functional layers (2, 2', 3, 3', 4, 4'), seen in cross-section through the substrate (1), are arranged directly adjacent to one another in the electronic component.

11. Process according to any one of claims 1 to 9,
**characterised in that**
between the at least two electrical functional layers (2, 2', 3, 3', 4, 4') seen in cross-section though the substrate (1), at least a third electrical functional layer is arranged at least in the surface region F in the electronic component.

12. Process according to claim 11,
**characterised in that**
the at least one third electrical functional layer, seen perpendicularly to the surface of the substrate (1), protrudes above the surface region F on all sides, whereby a third longitudinal dimension of the at least one third electrical functional layer parallel to the surface of the substrate (1) and in the relative movement direction, is designed at least 5µm longer than the longitudinal dimension (L_{F}) of the surface region F in the relative movement direction and parallel to the surface of the substrate (1), and whereby a third width dimension of the third electrical functional layer parallel to the surface of the substrate (1) and perpendicular to the relative movement direction is designed at least 5µm wider than a width dimension (B_{F}) of the surface area F perpendicular to the relative movement direction and parallel to the surface of the substrate (1).

13. Process according to claim 10,
**characterised in that**
the second electrical functional layer is designed as an electrical insulation layer or semiconductor layer.

14. Process according to claim 11,
**characterised in that**,
the second electrical functional layer is designed as one or several electrodes.

15. Process according to one of claims 1 to 14,
**characterised in that**
a field-effect transistor, a capacitor, a diode or a component containing at least one via, each with at least one organic electrical functional layer, is designed as an electronic component.

## Revendications

1. Procédé pour produire un composant électronique sur une surface d'un substrat (1), le composant électronique étant réalisé, lorsque vu perpendiculairement à la surface du substrat (1), avec au moins deux couches fonctionnelles électriques (2, 2', 3, 3', 4, 4') disposées en superposition et en chevauchement au moins dans une zone de surface F, ces couches fonctionnelles électriques (2, 2', 3, 3', 4, 4'), au moins au nombre de deux, étant structurées sur le substrat (1) de manière directe ou indirecte en un processus continu, le substrat (1) étant déplacé de manière relative à une unité de structuration, un substrat flexible d'une épaisseur dans la plage de 6 µm à 200 µm étant utilisé en guise de substrat, lequel est transporté d'un rouleau à l'autre au cours du processus continu, moyennant quoi :
a) une première couche fonctionnelle électrique des couches fonctionnelles électriques (2, 2', 3, 3', 4, 4'), au moins au nombre de deux, est structurée de manière à ce qu'une première dimension longitudinale (L₁) de la première couche fonctionnelle électrique est réalisée en parallèle à la surface du substrat (1) et dans une direction de déplacement relative du substrat (1) par rapport à l'unité de structuration avec une longueur d'au moins 5 µm de plus qu'une dimension longitudinale (L_{F}) de la zone de surface F en direction de déplacement relative et en parallèle à la surface du substrat (1), la première couche fonctionnelle électrique étant réalisée en tant qu'une ou plusieurs électrode(s), et
b) une première couche fonctionnelle électrique des couches fonctionnelles électriques (2, 2', 3, 3', 4, 4'), au moins au nombre de deux, étant structurée de manière à ce qu'une première dimension latérale (B₁) de la première couche fonctionnelle électrique est réalisée en parallèle à la surface du substrat (1) et perpendiculairement à une direction de déplacement relative du substrat (1) par rapport à l'unité de structuration avec une largeur d'au moins 5 µm de plus qu'une dimension latérale (B_{F}) de la zone de surface F perpendiculairement à la direction de déplacement relative et en parallèle à la surface du substrat (1).

2. Procédé selon la revendication 1, **caractérisé en ce que** la première dimension longitudinale (L₁) de la première couche fonctionnelle électrique est réalisée en direction de déplacement relative avec une longueur de 50 à 500 µm de plus que la dimension longitudinale (L_{F}) de la zone de surface F en direction de déplacement relative.

3. Procédé selon l'une des revendications 1 ou 2, **caractérisé en ce que** la première couche fonctionnelle électrique, compte tenu de la zone de surface F, est positionnée selon un lay-out de manière à ce qu'un premier centre de gravité de surface de la première couche fonctionnelle électrique et un centre de gravité de surface (S_{F}) de la zone de surface F se situent l'un au dessus de l'autre lorsque vus perpendiculairement au substrat (1).

4. Procédé selon l'une des revendications 1 à 3, **caractérisé en ce qu'**en guise de processus continu, on utilise un processus d'impression tel un processus d'impression en creux, en relief, à plat, par extrusion ou au tampon, un processus de structuration au laser, ou un processus de structuration photolithographique.

5. Procédé selon l'une des revendications 1 à 4, **caractérisé en ce que** l'on sélectionne une vitesse relative du substrat (1) par rapport à l'unité de structuration lors du processus continu dans la plage de 0,5 à 200 m/min.

6. Procédé selon l'une des revendications 1 à 5, **caractérisé en ce que** l'on utilise en guise de substrat (1) une feuille en matière synthétique allongée.

7. Procédé selon la revendication 6, **caractérisé en ce que** l'on choisit une épaisseur du substrat (1) dans la plage de 12 µm à 50 µm.

8. Procédé selon l'une des revendications 1 à 7, **caractérisé en ce que** les couches fonctionnelles électriques (2, 2', 3, 3', 4, 4'), au moins au nombre de deux, sont réalisées avec une épaisseur de couche respective dans la plage de 1 nm à 100 µm.

9. Procédé selon la revendication 8, **caractérisé en ce que** les couches fonctionnelles électriques (2, 2', 3, 3', 4, 4'), au moins au nombre de deux, sont réalisées avec une épaisseur de couche respective dans la plage de 10 nm à 300 nm.

10. Procédé selon l'une des revendications 1 à 9, **caractérisé en ce que** les couches fonctionnelles électriques (2, 2', 3, 3', 4, 4'), au moins au nombre de deux, sont disposées, lorsque vues en coupe transversale à travers le substrat (1), dans le composant électronique, de manière directement adjacente les unes par rapport aux autres.

11. Procédé selon l'une des revendications 1 à 9, **caractérisé en ce qu'**entre les couches fonctionnelles électriques (2, 2', 3, 3', 4, 4'), au moins au nombre de deux, en vue en coupe transversale à travers le substrat (1), dans le composant électronique, au moins une troisième couche fonctionnelle électrique est disposée au moins dans la zone de surface F.

12. Procédé selon la revendication 11, **caractérisé en ce que** cette ou ces troisième (s) couche (s) fonctionnelle(s) électrique(s), lorsque vue(s) perpendiculairement à la surface du substrat (1), dépasse(nt) de tous les côtés la zone de surface F, une troisième dimension longitudinale de cette ou ces troisième(s) couche(s) fonctionnelle(s) électrique(s) étant réalisée(s) parallèlement à la surface du substrat (1) et avec une longueur d'au moins 5 µm de plus en direction de déplacement relative que la dimension longitudinale (L_{F}) de la zone de surface F en direction de déplacement relative et parallèlement à la surface du substrat (1), et une troisième dimension latérale de la troisième couche fonctionnelle électrique étant réalisée parallèlement à la surface du substrat (1) et perpendiculairement à la direction de déplacement relative avec une largeur d'au moins 5 µm de plus qu'une dimension latérale (B_{F}) de la zone de surface F perpendiculairement à la direction de déplacement relative et parallèlement à la surface du substrat (1).

13. Procédé selon la revendication 10, **caractérisé en ce que** la deuxième couche fonctionnelle électrique est réalisée en tant que couche d'isolation électrique ou couche semi-conductrice.

14. Procédé selon la revendication 11, **caractérisé en ce que** la deuxième couche fonctionnelle électrique est réalisée en tant qu'une ou plusieurs électrode(s).

15. Procédé selon l'une des revendications 1 à 14, **caractérisé en ce que** l'on réalise, en guise de composant électronique, un transistor à effet de champ, un condensateur, une diode ou un composant contenant au moins un trou de liaison, avec respectivement au moins une couche fonctionnelle électrique organique.
